# EUROPEAN PATENT SPECIFICATION

(11) **EP 2 089 186 B1**
(45) Date of publication and mention of the grant of the patent: **06.07.2011**
(21) Application number: 08767884.3
(22) Date of filing: 27.05.2008
(51) Int. Cl.: B24B 37/04

(54) **APPARATUS FOR POLISHING A SEMICONDUCTOR WAFER**
VORRICHTUNG ZUR REINIGUNG EINES HALBLEITERWAFERS
DISPOSITIF DE POLISSAGE D'UNE TRANCHE DE SEMI-CONDUCTEUR

(30) Priority: 30.05.2007 US 807783
(43) Date of publication of application: 19.08.2009
(73) Proprietor: Corning Incorporated, Corning, NY 14831 (US)
(72) Inventor: EISENSTOCK, Gregory, Rochester, New York 14610 (US); THOMAS, John C, Elmira, New York 14905 (US)
(74) Representative: Greene, Simon Kenneth
(86) International application number: PCT/US2008/006690
(87) International publication number: WO 2008/153782

(56) References cited:
- US-A1- 2004 023 606
- US-A1- 2005 054 266

## Description

### BACKGROUND OF THE INVENTION

The present invention relates to methods and apparatus for polishing substrates using chemical mechanical polishing (CMP).

CMP is one accepted method of planarization (controlled polishing) of substrates used in, for example, semiconductor fabrication. The existing CMP methods typically require that the substrate be mounted on a carrier or polishing head. An exposed surface of the substrate is placed against a rotating polishing pad, which may be a standard pad or a fixed-abrasive pad. A standard pad has a durable roughened surface, whereas a fixed-abrasive pad has abrasive particles held in a containment media. The carrier head provides a controllable load, i.e., pressure, on the substrate to push it against the polishing pad. A polishing slurry, including a chemically-reactive agent (and abrasive particles if a standard pad is used) is applied to the surface of the polishing pad.

The CMP process provides a high polishing rate and a resulting substrate surface that is free from small-scale roughness and flat (lacking large-scale topography). The polishing rate, finish and flatness are determined by characteristics of the pad and slurry combination, the relative speed of the pad over the substrate, and the force pressing the substrate against the pad.

An existing rotating-belt type CMP processing apparatus 20 is illustrated in U.S. Patent Publication Number 2004/0209559. A rectangular platen 100 includes a polishing sheet 110 that advances via rollers over a top surface 140 of the platen 100. A carrier head 80 receives a substrate 10 for polishing, and applies a downward pressure of the substrate 10 against the polishing sheet 110. A fluid may be injected between a top surface 140 of the platen 100 and the polishing sheet 110 to create a fluid bearing therebetween. In addition to the information contained in U.S. Patent Publication Number 2004/0209559, further details as to the structure of the carrier head 80 may be found in U.S. Patent No. 6,183,354.

An aperture or hole 154 may be formed in the top surface 140 of the platen 100 and aligned with a transparent strip 118 in the polishing sheet 110. The aperture 154 and transparent strip 118 are positioned such that they permit a "view" of the substrate 10 during a portion of the platen's rotation. An optical monitoring system 90 includes a light source 94, such as a laser, and a detector 96. The light source generates a light beam 92 which propagates through aperture 154 and transparent strip 118 to impinge upon the exposed surface of substrate 10. The apparatus 20 uses the optical monitoring system 90 to determine the thickness of the substrate 10, to determine the amount of material removed from the substrate 10, or to determine when the surface has become planarized. A computer 280 may be programmed to activate the light source 94 when the substrate 10 overlies the aperture 154, to store measurements from the detector 96, to display the measurements on an output device 98, and to detect the polishing endpoint. In addition to the information contained in U.S. Patent Publication Number 2004/0209559, further details as to the structure of the optical monitoring system 90 and computer 280 may be found in U.S. Patent No. 5,893,796.

One of the problems with the aforementioned rotating-belt type CMP processing apparatus is that there is not adequate control over the amount and quality of the pressure between the substrate being polished and the rotating polishing sheet. Accordingly, there are needs in the art for new methods and apparatus for polishing via CMP which result in improved substrate finishes.
An apparatus according to the preamble of claim 1 is disclosed in document US 2004 - 0023606.

### SUMMARY OF THE INVENTION

The invention provides an apparatus with a moving abrasive belt according to claim 1.

The independent control of the actuators permits conformable finishing. Indeed, in some applications, such as LCD substrate finishing, a relatively large surface area substrate may have a distortion tolerance of around 20 µm, for example. A very thin layer or layers of material (on the order of a few to tens of nm in thickness) may require finishing, which layer(s) are conforming to the 20 um undulation of the substrate surface. In order to provide a precise finish on the thin layer(s), without removing the layer(s) entirely (as would occur in strict planarization), the finishing apparatus must compensate for the undulating surface of substrate while removing material from the thin layer(s).

In accordance with one or more embodiments of the present invention, methods and apparatus provide for: a base on which a substrate may be releasably coupled; a moving belt located with respect to the base such that a contact surface thereof is operable to remove material from a top surface of the substrate; and a plurality of actuators, at least two of which are independently controllable, located with respect to the base and the moving belt such that a corresponding plurality of pressure zones are defined to provide pressure between the moving belt and the top surface of the substrate.

The actuators include at least one fluid controlled actuator operable to vary the pressure between the moving belt and the top surface of the substrate in an associated one of the pressure zones as a function of a pressure of supplied fluid thereto.

The fluid controlled actuator includes at least one chamber and at least one pad in fluid communication with the chamber and one of the moving belt and a bottom surface of the substrate such that the pad is operable to vary the pressure between the moving belt and the top surface of the substrate in the associated pressure zone as a function of the pressure of the supplied fluid to the chamber.

The methods and apparatus may further provide for at least one optical detector circuit operable to monitor a thickness of the substrate in at least one of the pressure zones. A bottom surface of the substrate opposite the top surface may be coupled to a top surface of the base; and the base may include at least one aperture extending to the top surface thereof and located in the at least one pressure zone such that the optical detector circuit is operable to monitor the thickness of the substrate via the bottom surface thereof.

The base may include a plurality of such apertures extending to the top surface thereof, at least one aperture located in each pressure zone. The optical detector circuit may include a plurality of detectors, at least one of the plurality of detectors being operable to monitor the thickness of the substrate via the bottom surface thereof through a respective one of the apertures in respective ones of the pressure zones. The optical detector circuit may be operable to move in registration with respective ones of the apertures in order to monitor the thickness of the substrate via the bottom surface thereof through in respective ones of the pressure zones.

The methods and apparatus may further provide for a processor operating under control of a program and producing at least first and second signals in response to substrate thickness information provided by the optical detector circuit, wherein each of the first and second signals is operable to control the respective pressures provided by respective ones of the plurality of actuators. The processor may be operable to compute from the thickness information at least one of: a rate at which material is removed from the substrate by the moving belt; an amount of material that has been removed from the substrate by the moving belt; and a variation in thickness of the substrate.

Other feature and advantages of the present invention will be apparent to one skilled in the art from the description herein taken in conjunction with the accompanying drawings.

### DESCRIPTION OF THE DRAWINGS

For the purposes of illustration, there are forms shown in the drawings, some of which are not embodiments of the invention.

FIG. 1 is a side cross-sectional elevational view of an apparatus for polishing a substrate in accordance with one or more aspects of the present invention;

FIG. 2 is block diagram of a closed-loop control circuit suitable for use with the apparatus of FIG. 1;

FIG 3B is an implementation for the actuators used in the apparatus of FIG. 1 to apply pressure to the substrate; Figs. 3A, 4 and 5 are representations of actuators which do not form embodiments of the invention; and

FIG. 6 is a cross-sectional view of an abrasive member suitable for use with the apparatus of FIG. 1.

### DETAILED DESCRIPTION OF THE PREFERRED EMBODIMENTS

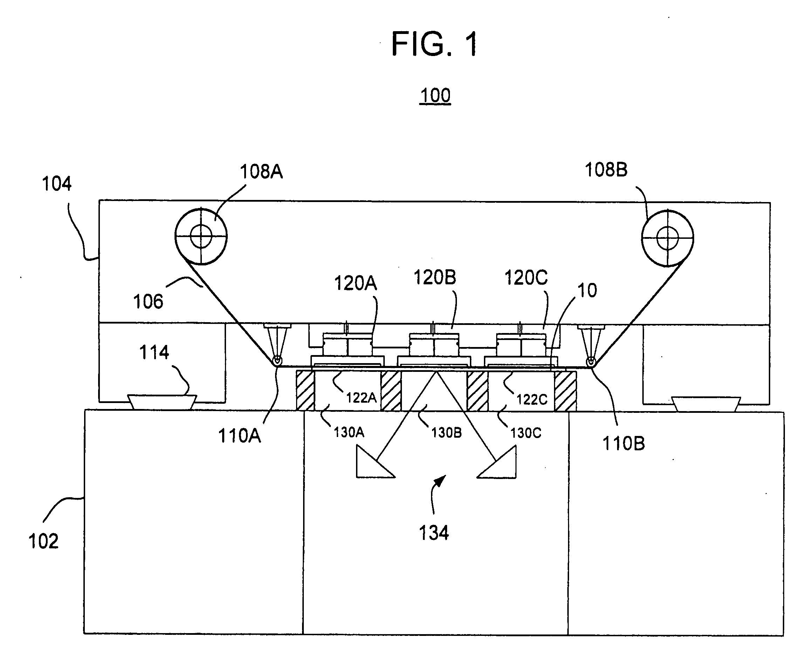

With reference to the drawings, wherein - like numerals indicate like elements, there is shown in FIG. 1 a cross-sectional side view of a CMP apparatus 100 in accordance with one or more embodiments of the present invention. The CMP apparatus 100 is operable to remove material, e.g., polish, a substrate 10 in a controlled fashion to achieve a highly uniform, polished surface.

The substrate may be any material, such as glass, glass ceramic, semiconductor, and combinations of the above, such as semiconductor on insulator (SOI) structures. In the case of semiconductor materials, such may be taken from the group comprising: silicon (Si), germanium-doped silicon (SiGe), silicon carbide (SiC), germanium (Ge), gallium arsenide (GaAs), GaP, and InP.

The CMP apparatus 100 includes a base 102 and an upper structure 104 coupled thereto. The upper structure 104 includes a moving member having an abrasive contact surface that is operable to remove material from a top surface of the substrate 10. The moving abrasive member is a moving belt 106 that is guided over the top surface of the substrate 10 at a controllable rate and pressure. A number of rollers, such as primary rollers 108A, 108B and secondary rollers 110A 110B are employed to drive and guide the moving belt 106 across the top surface of the substrate 10. The upper structure 104 also includes a frame or chassis that positions the rollers 108, 110, and therefore the moving belt 106, with respect to the base 102 to achieve suitable clearances and engagement of the moving belt 106 against the substrate 10. The moving belt 106 may exhibit both rotational movement (e.g., via rollers 108, 110), as well as translational movement as will be discussed further below.

The upper structure 104 includes a plurality of actuators 120 that operate to urge the moving belt 106 against the top surface of the substrate 10 in order to create a suitable amount of pressure therebetween. At least two, and preferably all, of the actuators 120 are independently controllable such that respective pressure zones 122A, 122B, 122C ... are defined at the top surface of the substrate 10. Consequently, independent control of each actuator 120 results in the same or different pressures at the respective pressure zones 122, thereby enabling variability in the applied pressure between the moving belt 106 and the substrate 10 as well as variability in the location of such pressure.

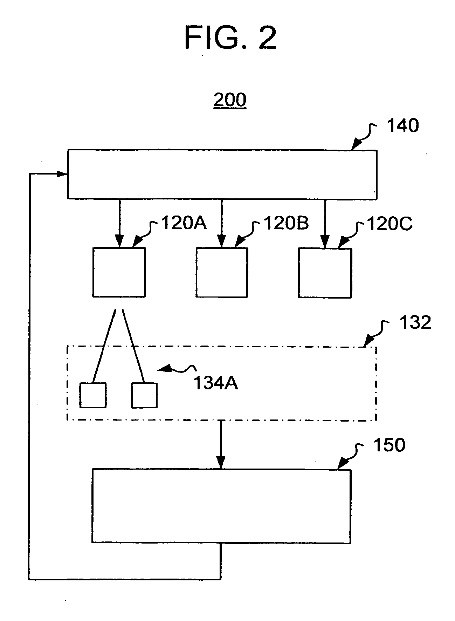

The base 102 may include a plurality of apertures 130A, 130B, 130C ... extending to a top surface of the base 102. At least one aperture 130 is located in each pressure zone 122 so that a bottom surface of the substrate 10 may be viewed through such aperture 130. The CMP apparatus 100 also includes at least one optical detector circuit 132 (FIG. 2) that is operable to monitor a thickness of the substrate 10 in at least one of the pressure zones 122 through the associated aperture 130. The optical detector circuit 132 may include a plurality of optical detectors 134A, 134B, 134C ..., where at least one (and preferable each) of the optical detectors 134 are operable to monitor the thickness of the substrate 10 via the bottom surface of the substrate 10 through respective apertures 130. In other words, the optical detectors 134 are operable to sense the thickness of the substrate 10 by inducing light through the substrate 10 from below the bottom surface thereof. The optical detector(s) 134 may be implemented using known interferometer technologies. The optical detector(s) 134 may include a light source, such as a laser, and a detector. The light source generates a light beam which propagates through aperture 130 to impinge upon the exposed bottom surface of the substrate 10.

In an alternative embodiment, the optical detector circuit may include a single optical detector 134 that is operable to move in registration with respective ones of the apertures 130A, 130B, 130C ... in order to monitor the thickness of the substrate 10 at each one of the pressure zones 122. Irrespective of the particular implementation of the optical detector circuit 132, the combination of the plurality of actuators 120 and optical detection results is highly regulated control of the pressures in the respective pressure zones 122 as well as corresponding monitoring of the removal of material from the substrate 10.

With reference to FIG. 2, a schematic diagram is shown of a closed-loop control system 200 suitable for use in combination with the CMP apparatus 100. The control system 200 includes the actuators 120, the optical detector circuit 132, an energy source circuit 140, and a processor circuit 150. As discussed above, the actuators 120 are operable to urge the moving belt 106 against the top surface of the substrate 10 at respective pressure zones 122. The actuators 120 receive input from the energy source circuit 140 such that each actuator 120A, 120B, 120C ... is capable of independent actuation and resultant pressure. The optical detector circuit 132 monitors the thickness of the substrate 10 in each of the pressure zones 122 and provides such thickness information to the processor circuit 150. The processor circuit 150 receives the substrate thickness information and utilizes same to provide controlled signaling to the energy source circuit 140. The processor circuit 150 may be implemented utilizing any of the known micro-processor chip sets that operate under the control of a software program.

By way of example, the processor circuit 150 may utilize the substrate thickness information to compute a rate at which material is removed from the substrate 10, and aggregate amount of material that has been removed from the substrate 10, a variation of the thickness of the substrate 10 from zone-to-zone, etc. The processor circuit 150 utilizes the substrate thickness information, and/or the computational results thereof, to produce one or more control signals to the energy source circuit 140 such that variable amounts of energy may be provided to the actuators 120 in order to achieve desirable pressures at the respective pressure zones 122. In this way, highly regulated control of the removal of the material from the top surface of the substrate 10 may be achieved.

Referring to FIG. 1, the upper structure 104 is operable to move (or slide) perpendicularly with respect to the direction of the moving belt 106. In the illustrated embodiment, the upper structure 104 is operable to move in a direction corresponding to movement into and out of the page via slides 114. The sliding action of the upper structure 104 via the slides 114 avoids directional marking that might otherwise occur from the moving belt 106. For example, the speed and movement characteristics of the rollers 108, 110 and the slides may be controlled such that desirable movement of the belt 106 with respect to the substrate may be achieved. The motion pattern may be simple or complex, such as circular patterns, sinusoidal patters, etc.

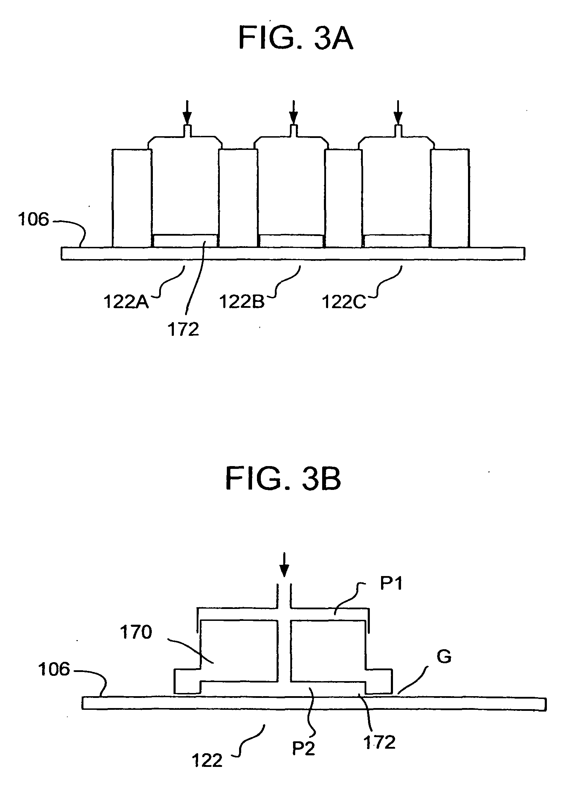

Reference is now made to FIGS. 3-5, which are simplified cross-sectional views of various embodiments and comparative examples suitable for implementing the actuators 120. The comparative example FIG.3A shows that the actuators 120 may be fluid controlled, whereby an increase in the supplied fluid pressure results in an increase in the pressure of the moving belt 106 against the substrate 10 in the associated pressure zone 122. Each actuator 120 includes at least one movable pad 172 such that an increase in the pressure of the fluid within the actuator 120 results in a biasing of the pad 172 toward an inside surface of the moving belt 106 (opposite to the contact surface). A lubricating fluid may be provided between the pad 172 and the inside surface of the moving belt 106 in order to reduce friction therebetween.

FIG. 3B illustrates an embodiment in which the actuators 120 are implemented using self-compensating hydrostatic pads (one such actuator being shown for simplicity). The actuator 120 includes a movable member 170 situated between pressure zones P1 and P2. An orifice extends between the pressure zones P1, P2, which acts to equalize the pressures therebetween. The pressurized fluid in pressure zone P2 acts as a hydrostatic pad 172 for biasing the belt 106 against the substrate 10. Fluid escapes through the gap G, but is self-regulated, in order to ensure a programmed pressure is achieved at the hydrostatic pad 172. Specifically, if the gap G is too large (resulting in excessive leakage), the pressure at P2 drops below the pressure at P1. This pressure imbalance causes the moving member 170 to advance toward the belt 106, thereby closing the gap G and equalizing the pressure at P1 and P2.

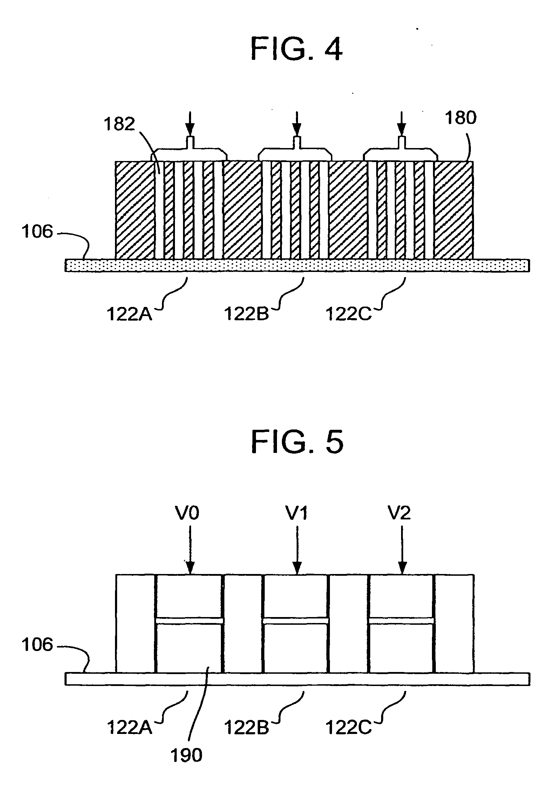

FIG. 4 illustrates a comparative example in which the actuators 120 are implemented by way of a plate 180 that includes a plurality of bores 182 therethrough, where respective groups of bores are located in the respective pressure zones 122. First ends of the bores 182 communicate with a fluid supply and second ends of the bores 182 communicate with the inside surface of the moving belt 106. Thus, an increase or decrease in the pressure of the supplied fluid through the bores 182 results in a corresponding increase or decrease in the pressure of the moving belt 106 at the pressure zone 122.

FIG. 5 illustrates a comparative example in which the respective actuators 120 are implemented utilizing piezoelectric actuators 190. Variation in the voltage supplied to the respective piezoelectric actuators 190 results in a corresponding variation in the pressure of the moving belt 106 against the substrate 10. Piezoelectric actuators 190 suitable for use in connection with the embodiments herein may be obtained from Physik Instrumente L.P., Auburn, MA.

It is noted that, in the illustrated embodiments, the actuators 120 are positioned to engage the inside surface of the moving belt 106 in order to provide pressure thereto. In alternative embodiments, the actuators 120 may be located such that they urge the substrate against the moving belt 106. In such embodiments, however, the optical detector circuitry 132 would need to be relocated opposite to the actuators 120 and means provided to permit the optical detection of the thickness of the substrate 10 through the moving belt 106.

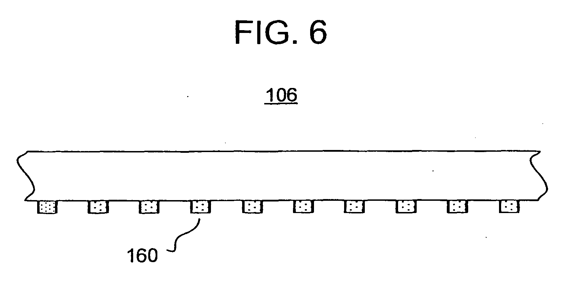

With reference to FIG. 6, at least a portion of the moving belt 106 includes a fixed abrasive structure, which is a micro-replicated pattern of micron-sized posts 160 on the contact surface thereof. The posts 160 contain an abrasive material in a resin-like matrix. The fixed abrasive materials may be obtained from the 3M Company, St. Paul, MN. Such an embodiment is believed to be advantageous when polishing silicon on glass (SiOG) substrates. Using conventional polishing techniques, the abrasive particles reach the exposed surface of the substrate under treatment, and removal of material occurs both on elevated and lower areas of the abrasive material. In the case of fixed abrasive polishing using the micro-replicated pattern of micron-sized posts 160, the abrasive particles are bound in the elevated posts 160 of the pad. Thus removal of material occurs mainly at the elevated areas of the exposed posts 160. Thus, the material removal rate, expressed as a ratio of removal between topographically higher versus lower areas of the substrate 10, is much higher than in the case of conventional techniques, such as slurry-based CMP.

Advantages of one or more embodiments of the present invention include application in sub-aperture finishing and full aperture finishing. Sub-aperture finishing may be defined as a context in which the available finishing surface of the abrasive member is smaller than the object (e.g., substrate) being finished. Thus, in sub-aperture finishing, there must be some movement (e.g., raster pattern) of the available finishing surface over the substrate to finish the desired surface area of the substrate. Full-aperture finishing may be defined as a context in which the available finishing surface of the abrasive member is larger than the substrate being finished. The independently controllable actuators and resultant independent control zones permit conformable finishing as opposed to strict planarization (although planarization may also be achieved). Additionally, compensation in tolerances of the finishing apparatus due to temperature and structural deformation may be achieved, such that highly precise finishing results.

Although the invention herein has been described with reference to particular embodiments, it is to be understood that the scope of the present invention is defined by the appended claims.

## Claims

1. An apparatus for chemical mechanical polishing comprising:
a base (102) on which a substrate (10) may be releasably coupled;
a moving abrasive belt (106) located with respect to the base (102) such that a contact surface thereof is operable to remove material from a top surface of the substrate (10); and
a plurality of actuators (120), at least two of which are independently controllable, located with respect to the base (102) and the moving abrasive belt (106) such that a corresponding plurality of pressure zones (122A, 122B, 122C, P1, P2) are defined to provide pressure between the moving abrasive belt (106) and the top surface of the substrate (10);
wherein the actuators (120) include at least one fluid controlled actuator, **characterized in that** the at least one fluid controlled actuator includes at least one movable member (170) arranged to define a self compensating hydrostatic pad (172,P2) in fluid communication with the moving belt (106) such that the movable member (170) is operable to vary the pressure between the moving abrasive belt (106) and the top surface of the substrate in an associated one of the pressure zones (P2) as a function of a pressure of supplied fluid thereto.

2. The apparatus of claim 1, wherein the self-compensating hydrostatic pad (172) is directly or indirectly engageable with a surface of the moving abrasive belt (106) opposite the contact surface such that the self-compensating hydrostatic pad (172) is operable to urge the moving abrasive belt (106) against the top surface of the substrate (10) as a function of the pressure of the supplied fluid to the chamber.

3. The apparatus of one of claims 1 or 2, wherein the movable member (170) is situated between first (P1) and second (P2) pressure zones, the second pressure zone (P2) including the volume of fluid comprising the hydrostatic pad (172), in communication with one of the moving abrasive belt (106) and a bottom surface of the substrate (10).

4. The apparatus of claim 3, wherein the movable member (170) includes at least one orifice extending between the first (P1) and second (P2) pressure zones to permit fluid to flow from the first pressure zone to the second pressure zone.

5. The apparatus of claim 4, wherein the at least one orifice extends through the movable member (170) from the first pressure zone (P1) to the second pressure zone (P2).

6. The apparatus of one of claims 3 through 5 wherein the movable member (170) is spaced away from the moving abrasive belt (106), thereby forming a gap (G) therebetween trough which the fluid flows from the second pressure zone.

7. The apparatus of one of claims 3 through 6, wherein:
the gap (G) varies as the spacing between the movable member (170) and the moving abrasive belt (106) varies; and
the pressure in the second pressure zone (P2) decreases below the pressure in the first pressure zone as the gap (G) increases, and the pressure difference causes the movable member (170) to advance and reduce the gap (G) and equalize the pressure between the first (P1) and second pressure (P2) zones, such that the hydrostatic pad (172) is self compensating and operates to equalize the pressure between the moving abrasive belt (106) and the top surface of the substrate in the associated pressure zone.

## Patentansprüche

1. Vorrichtung zum chemisch-mechanischen Polieren, umfassend:
eine Basis (102), auf welcher ein Substrat (10) lösbar befestigt werden kann;
ein sich bewegendes Schleifband (106), das derart zur Basis (102) angeordnet ist, dass eine Kontaktoberfläche dessen so funktionsfähig ist, dass Material von einer oberen Oberfläche des Substrats (10) entfernt wird; sowie
eine Vielzahl von Betätigern (120), von denen mindestens zwei unabhängig voneinander steuerbar sind, die derart zur Basis (102) und dem sich bewegenden Schleifband (106) angeordnet sind, dass eine entsprechende Mehrzahl an Druckzonen (122A, 122B, 122C, P1, P2) derart definiert sind, dass ein Druck zwischen dem sich bewegenden Schleifband (106) und der oberen Oberfläche des Substrats (10) zur Verfügung gestellt wird;
wobei die Betätiger (120) mindestens einen flüssigkeitsgesteuerten Betätiger umfassen, **dadurch gekennzeichnet, dass**
der mindestens eine flüssigkeitsgesteuerte Betätiger mindestens ein bewegbares Element (170) umfasst, das so angeordnet ist, dass ein selbstkompensierendes hydrostatisches Pad (172, P2) in Fluidverbindung mit dem sich bewegenden Band (106) definiert ist, so dass das bewegbare Element (170) so funktionsfähig ist, dass der Druck zwischen dem sich bewegenden Schleifband (106) und der oberen Oberfläche des Substrats in einer zugeordneten Druckzone (P2), die damit in Verbindung steht, in Abhängigkeit von einem Druck der ihr zugeführten Flüssigkeit variiert wird.

2. Vorrichtung nach Anspruch 1, wobei das selbstkompensierende hydrostatische Pad (172) direkt oder indirekt mit einer Oberfläche des sich bewegenden Schleifbands (106) gegenüber der Kontaktoberfläche in Eingriff gebracht werden kann, so dass das selbstkompensierende hydrostatische Pad (172) so funktionsfähig ist, dass das sich bewegende Schleifband (106) in Abhängigkeit von dem Druck der Flüssigkeit, die der Kammer zugeführt wird, gegen die obere Oberfläche des Substrats (10) getrieben wird.

3. Vorrichtung nach einem der Ansprüche 1 oder 2, wobei das bewegliche Element (170) zwischen der ersten (P1) und zweiten (P2) Druckzone angeordnet ist, wobei die zweite Druckzone (P2), die das Volumen der Flüssigkeit umfasst, das hydrostatische Pad (172) umfasst, in Kommunikation mit einem aus dem sich bewegenden Schleifband (106) und der unteren Oberfläche des Substrats (10).

4. Vorrichtung nach Anspruch 3, wobei das bewegliche Element (170) mindestens eine Öffnung umfasst, die zwischen der ersten (P1) und zweiten (P2) Druckzone herausreicht, um zu erlauben, dass Flüssigkeit von der ersten Druckzone zur zweiten Druckzone fließt.

5. Vorrichtung nach Anspruch 4, wobei sich die mindestens eine Öffnung durch das bewegbare Element (170) von der ersten Druckzone (P1) zur zweiten Druckzone (P2) erstreckt.

6. Vorrichtung nach einem der Ansprüche 3 bis 5, wobei das bewegliche Element (170) in einem Abstand von dem beweglichen Schleifband (106) angeordnet ist, wobei eine Lücke (G) zwischen den beiden gebildet wird, durch welche die Flüssigkeit von der zweiten Druckzone fließt.

7. Vorrichtung nach einem der Ansprüche 3 bis 6, wobei:
die Lücke (G) variiert wenn sich der Abstand zwischen dem beweglichen Element (170) und dem sich bewegenden Schleifband (106) variiert; und
der Druck in der zweiten Druckzone (P2) unter den Druck in der ersten Druckzone sinkt, wenn sich die Lücke (G) vergrößert, und der Druckunterschied bewirkt, dass das sich bewegende Element (170) vorrückt und die Lücke (G) verringert und den Druck zwischen den ersten (P1) und zweiten (P2) Druckzone ausgleicht, so dass das hydrostatische Pad (172) selbstkompensierend ist und so funktioniert, dass der Druck zwischen dem sich bewegenden Schleifband (106) und der oberen Oberfläche des Substrats in der verbundenen Druckzone ausgeglichen wird.

## Revendications

1. Appareil de polissage mécanique chimique comprenant :
une base (102) à laquelle un substrat (10) peut être couplé de façon amovible ;
une courroie abrasive mobile (106) placée relativement à la base (102) de telle sorte qu'une surface de contact de celle-ci soit actionnable pour éliminer la matière d'une surface supérieure du substrat (10) ; et
une pluralité d'actionneurs (120), dont au moins deux peuvent être commandés indépendamment, situés relativement à la base (102) et à la courroie abrasive mobile (106) de telle sorte qu'une pluralité correspondante de zones de pression (122A, 122B, 122C, P1, P2) soit définie pour produire une pression entre la courroie abrasive mobile (106) et la surface supérieure du substrat (10) ;
dans lequel les actionneurs (120) comportent au moins un actionneur commandé par fluide, **caractérisé en ce que** l'au moins un actionneur commandé par fluide comporte au moins un élément mobile (170) agencé pour définir un patin hydrostatique autocompensateur (172, P2) en communication fluide avec la courroie mobile (106) de telle sorte que l'élément mobile (170) soit actionnable pour faire varier la pression entre la courroie abrasive mobile (106) et la surface supérieure du substrat dans une zone associée des zones de pression (P2) en fonction de la pression du fluide alimenté à celle-ci.

2. Appareil selon la revendication 1, dans lequel le patin hydrostatique autocompensateur (172) peut être mis en prise directement ou indirectement avec une surface de la courroie abrasive mobile (106) à une position opposée à la surface de contact de telle sorte que le patin hydrostatique autocompensateur (172) soit actionnable pour pousser la courroie abrasive mobile (106) contre la surface supérieure du substrat (10) en fonction de la pression du fluide alimenté à la chambre.

3. Appareil selon l'une des revendications 1 ou 2, dans lequel l'élément mobile (170) est situé entre des première (P1) et seconde (P2) zones de pression, la seconde zone de pression (P2) comportant le volume de fluide comprenant le patin hydrostatique (172), en communication avec l'une de la courroie abrasive mobile (106) et d'une surface inférieure du substrat (10).

4. Appareil selon la revendication 3, dans lequel l'élément mobile (170) comporte au moins un orifice s'étendant entre les première (P1) et seconde (P2) zones de pression pour permettre à un fluide de s'écouler depuis la première zone de pression jusqu'à la seconde zone de pression.

5. Appareil selon la revendication 4, dans lequel l'au moins un orifice s'étend à travers l'élément mobile (170) depuis la première zone de pression (P1) jusqu'à la seconde zone de pression (P2).

6. Appareil selon l'une des revendications 3 à 5, dans lequel l'élément mobile (170) est espacé de la courroie abrasive mobile (106), formant ainsi un espace (G) entre eux à travers lequel s'écoule le fluide provenant de la seconde zone de pression.

7. Appareil selon l'une des revendications 3 à 6, dans lequel :
l'espace (G) varie au fur et à mesure que l'espacement entre l'élément mobile (170) et la courroie abrasive mobile (106) varie ; et
la pression dans la seconde zone de pression (P2) diminue en dessous de la pression dans la première zone de pression au fur et à mesure que l'espace (G) augmente, et la différence de pression amène l'élément mobile (170) à avancer et à réduire l'espace (G) et à égaliser la pression entre la première (P1) et la seconde (P2) zones de pression, de telle sorte que le patin hydrostatique (172) soit autocompensateur et fonctionne pour égaliser la pression entre la courroie abrasive mobile (106) et la surface supérieure du substrat dans la zone de pression associée.
